(19) **Europäisches Patentamt / European Patent Office / Office européen des brevets**

(11) **EP 2 995 648 A1**

(12) **EUROPEAN PATENT APPLICATION**
published in accordance with Art. 153(4) EPC

(43) Date of publication:
**16.03.2016 Bulletin 2016/11**

(21) Application number: **14795337.6**

(22) Date of filing: **09.05.2014**

(51) Int Cl.:
**C08L 67/00** (2006.01)     **C08K 3/00** (2006.01)
**C08K 7/14** (2006.01)     **H01L 33/60** (2010.01)

(86) International application number:
**PCT/JP2014/002455**

(87) International publication number:
**WO 2014/181548 (13.11.2014 Gazette 2014/46)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **10.05.2013   JP 2013100114**

(71) Applicant: **Mitsui Chemicals, Inc.
Tokyo 105-7117 (JP)**

(72) Inventors:
• **EBATA, Hiroki**
  **Chiba 299-0265 (JP)**
• **OGASAWARA, Hideto**
  **Chiba 299-0265 (JP)**
• **WASHIO, Isao**
  **Chiba 299-0265 (JP)**
• **KAGEYAMA, Fumio**
  **Chiba 299-0265 (JP)**
• **TAKIZAWA, Nobuhiro**
  **Chiba 299-0265 (JP)**
• **AMANO, Akinori**
  **Chiba 299-0265 (JP)**
• **HAMA, Takashi**
  **Chiba 299-0265 (JP)**

(74) Representative: **Hoffmann Eitle
Patent- und Rechtsanwälte PartmbB
Arabellastraße 30
81925 München (DE)**

(54) **POLYESTER RESIN COMPOSITION FOR REFLECTIVE MATERIAL AND REFLECTOR INCLUDING SAME**

(57)     The present invention is directed to a polyester resin composition for providing a reflector having excellent mechanical strength and heat resistance, maintaining high reflectance even in a heated environment such as an LED manufacturing process or a reflow soldering process, and having small change in shrinkage rate. The polyester resin composition for a reflective material is a composition comprising 30 to 80% by mass of a polyester resin (A) with a melting point or a glass transition temperature of 250°C or more, 10 to 35% by mass of a glass fiber (B) with a minor axis of 3 to 8 $\mu$m, 5 to 50% by mass of a white pigment (C), and 0.3 to 1.5% by mass of an olefin polymer (D) containing 0.2 to 1.8% of a functional group structural unit (all based on a total of (A), (B), (C) and (D) which is 100% by mass).

COMPLETELY CIRCULAR SHAPE

FIG. 1A

COCOON SHAPE

FIG. 1B

ELLIPTICAL SHAPE

FIG. 1C

EP 2 995 648 A1

**Description**

Technical Field

The present invention relates to a polyester resin composition for a reflective material, and a reflector including the same.

Background Art

Light sources such as light-emitting diodes (hereinafter, referred to as LEDs) and organic ELs have been widely used as illumination as well as backlights of displays, taking advantage of features of low power consumption and long life, and are likely to be increasingly used in the future. In order to efficiently utilize light from these light sources, reflectors have been utilized in various phases. On the other hand, electronic devices have been notably miniaturized; above all, portable devices typified by mobile phones and notebook computers have been remarkably lighter, thinner and smaller, and capabilities required for reflectors have also been changing.

That is, reflectors are required to stably exhibit high reflectance under the operating environment, and also required are, for example, mechanical strength and heat resistance (heat resistance in an environment higher than 250°C is required since surface mounting on a printed circuit board (by reflow soldering process, etc.) is also conducted).

Further, in recent years, due to the requirements for cost reduction of products, there is a tendency to decrease the number of LED packages installed in final products such as TVs and displays. In accordance with such tendencies, light sources have been improved to have higher luminance, and as a result, reflectors have been required to have a capacity of suppressing the lowering of reflectance under a more severe heat-resistant environment.

Furthermore, in order to cope with thinner electronic products, side-view type (in which light is irradiated in a direction parallel to a mounting surface) LED packages have been developed. Since the side-view type LED packages are designed to be smaller and to have a thinner package side wall, the reflectors are required to have a strength property higher than ever before. In addition, since slight thermal shrinkage of a molded product may cause a crack to occur on the package, low shrinkage is also required for the material.

There are often cases where polyamide materials are used for the reflector. However, polyamide materials may sometimes cause discoloration due to a terminal amino group or an amide bond, i.e., may sometimes cause the lowering of reflectance. Under such circumstances, there is disclosed a technique for suppressing the lowering of reflectance by improving a base polymer of the reflector. For example, there is an attempt to use a heat-resistant polyester in place of a polyamide resin (PTL 1).

Citation List

Patent Literature

PTL 1
Japanese Unexamined Patent Application Publication (Translation of PCT Application) No. 2009-507990

Summary of Invention

Technical Problem

PTL 1 discloses the change of a base polymer of a resin composition constituting a reflective material from polyamide to a heat-resistant polyester. However, the change of a base polymer may sometimes cause a problem of lowering the mechanical strength of the reflective material. Thus, it has been considered to enhance the strength and the toughness of the reflective material by combining a heat-resistant polyester with a glycidyl methacrylate polymer.

According to the studies by the present inventors, it is found that a composition containing a heat-resistant polyester and a glycidyl methacrylate polymer is excellent in balance of mechanical strength such as toughness, whereas such a composition has problems in terms of stability of reflectance over time and melt-flowability as a resin composition. Therefore, further improvements are required.

Thus, the present invention provides a polyester resin composition for a reflective material having particularly excellent mechanical strength and heat resistance, while being capable of maintaining high reflectance even when being exposed to heated environments such as LED manufacturing process (process in which an LED element is assembled into a reflective material) and reflow soldering process, making it possible to obtain a reflector with less variation of shrinkage rate. In addition, the present invention provides a reflector containing the resin composition.

Solution to Problem

As a result of intensive studies in view of such circumstances, the present inventors have found that a composition containing a thermoplastic resin having a high melting point or glass transition temperature, an inorganic filler having a specific structure, a white pigment, and an olefin polymer having a specific structure has heat resistance, mechanical strength, moldability and the stability of reflectance over time all at a high level, and have completed the present invention.
That is, a first aspect of the present invention relates to a polyester resin composition for a reflective material, as set forth below.

[1] A polyester resin composition for a reflective material, containing 30 to 80% by mass of a polyester resin (A) having a melting point (Tm) or glass transition temperature (Tg) of 250°C or more measured by a differential scanning calorimeter (DSC), 10 to 35% by mass of a glass fiber (B) having a minor axis of fiber cross-section of 3 to 8 $\mu$m, 5 to 50% by mass of a white pigment (C), and 0.3 to 1.5% by mass of an olefm polymer (D) containing 0.2 to 1.8% by mass of a functional group structural unit containing a hetero atom, all based on a total of (A), (B), (C) and (D) which is 100% by mass.

[2] The polyester resin composition for a reflective material according to [1], in which the polyester resin (A) is a polyester resin (A-1) containing a dicarboxylic acid component unit (a-1) containing 30 to 100% by mole of a dicarboxylic acid component unit derived from terephthalic acid and 0 to 70% by mole of an aromatic dicarboxylic acid component unit other than terephthalic acid, and a $C_4$-$C_{20}$ alicyclic dialcohol component unit (a-3) and/or aliphatic dialcohol component unit (a-4).

[3] The polyester resin composition for a reflective material according to [2], in which the alicyclic dialcohol component unit (a-3) has a cyclohexane skeleton.

[4] The polyester resin composition for a reflective material according to any one of [1] to [3], in which the ratio between the minor axis and a major axis of the fiber cross-section (irregular shape ratio) of the glass fiber (B) is 3 to 8.

[5] The polyester resin composition for a reflective material according to any one of [1] to [4], in which the functional group structural unit of the olefin polymer (D) includes a functional group selected from a carboxylic acid, an ester, an ether, an aldehyde and a ketone.

[6] The polyester resin composition for a reflective material according to [5], in which the functional group structural unit of the olefin polymer (D) includes a maleic anhydride structural unit.

[7] The polyester resin composition for a reflective material according to any one of [1] to [6], in which the olefin polymer (D) contains a polyolefin-derived skeleton, and the polyolefin-derived skeleton is a copolymer of ethylene and an olefin having 3 or more carbon atoms.

[8] The polyester resin composition for a reflective material according to any one of [1] to [7], further containing a phosphorus-containing antioxidant (E).

[9] The polyester resin composition for a reflective material according to [8], containing 0 to 10 parts by mass of the phosphorus-containing antioxidant (E) per 100 parts by mass of a total of the polyester resin (A), the glass fiber (B), the white pigment (C) and the olefin polymer (D).

A second aspect of the present invention relates to a reflector, as set forth below.

[10] A reflector containing the polyester resin composition for a reflective material according to [1].

[11] The reflector according to [10], which is a reflector for a light-emitting diode element.

Advantageous Effects of Invention

The polyester resin composition for a reflective material of the present invention is used suitably as a raw material for the reflective material, and is stable even at high temperature. Therefore, the molding, preferably insert molding of the polyester resin composition for a reflective material of the present invention enables an obtainment of a reflector excellent in reflectance, heat resistance and mechanical properties.

Brief Description of Drawing

FIG. 1A is a schematic view illustrating cross-sectional shapes of glass fiber (B) contained in the resin composition of the present invention;

FIG. 1B is a schematic view illustrating cross-sectional shapes of glass fiber (B) contained in the resin composition of the present invention;

FIG. 1C is a schematic view illustrating cross-sectional shapes of glass fiber (B) contained in the resin composition of the present invention;

FIG. 2 is a photograph of fiber cross-sections of glass fibers contained in the resin composition of the present invention, observed by an electron microscope; and

FIG. 3 is a photograph of fiber cross-sections of glass fibers contained in a molded product of the resin composition of the present invention, observed by an electron microscope.

Description of Embodiments

1. Polyester Resin Composition for Reflective Material

The polyester resin composition for a reflective material of the present invention contains a polyester resin (A), a glass fiber (B), a white pigment (C), and an olefin polymer (D).

1-1. Polyester Resin (A)

The polyester resin (A) contained in the polyester resin composition for a reflective material preferably contains at least a component unit derived from an aromatic dicarboxylic acid, and a component unit derived from a dialcohol having a cyclic skeleton.

Examples of the component unit derived from a dialcohol having a cyclic skeleton include a component unit derived from an alicyclic dialcohol and a component unit derived from an aromatic dialcohol; from the viewpoints of heat resistance and moldability, the polyester resin (A) preferably contains the component unit derived from an alicyclic dialcohol.

The polyester resin (A) is preferably a polyester resin (A-1) containing a specific dicarboxylic acid component unit (a-1), an alicyclic dialcohol component unit (a-3) and/or aliphatic dialcohol component unit (a-4).

The specific dicarboxylic acid component unit (a-1) in the polyester resin (A1) preferably contains 30 to 100% by mole of a terephthalic acid component unit, and 0 to 70% by mole of an aromatic dicarboxylic acid component unit other than terephthalic acid. The total amount of the dicarboxylic acid component units in the dicarboxylic acid component unit (a-1) is 100% by mole.

Here, preferred examples of the aromatic dicarboxylic acid component unit other than terephthalic acid include isophthalic acid, 2-methyl terephthalic acid and naphthalene dicarboxylic acid, and a combination thereof.

The amount of the terephthalic acid component unit contained in the dicarboxylic acid component unit (a-1) is more preferably 40 to 100% by mole, and even more preferably 40 to 80% by mole. The amount of the aromatic dicarboxylic acid component unit other than terephthalic acid contained in the dicarboxylic acid component unit (a-1) is more preferably 0 to 60% by mole, and, for example, may be 20 to 60% by mole.

Here, the polyester resin (A1) may further contain a small amount of the aliphatic dicarboxylic acid component unit as the dicarboxylic acid component unit (a-1), together with the above-mentioned structural units, in a range that does not impair the effect of the present invention. The amount of the aliphatic dicarboxylic acid component unit contained in the dicarboxylic acid component unit (a-1) is preferably 10% by mole or less.

The number of carbon atoms contained in the aliphatic dicarboxylic acid component unit is not particularly limited, but is preferably 4 to 20, and more preferably 6 to 12. Examples of the aliphatic dicarboxylic acid used for deriving the aliphatic dicarboxylic acid component unit include adipic acid, suberic acid, azelaic acid, sebacic acid, decane dicarboxylic acid, undecane dicarboxylic acid, and dodecane dicarboxylic acid; and adipic acid may be preferred.

In addition, the polyester resin (A1) may further contain, for example, 10% by mole or less of a polyvalent carboxylic acid component unit as the dicarboxylic acid component unit (a-1). Specific examples of such a polyvalent carboxylic acid component unit may include a tribasic acid and a polybasic acid, such as trimellitic acid and pyromellitic acid.

It is also possible for the polyester resin (A1) to further contain a component unit derived from the alicyclic dicarboxylic acid such as cyclohexanedicarboxylic acid.

The alicyclic dialcohol component unit (a-3) in the polyester resin (A1) preferably contains a component unit derived from a dialcohol having a $C_4$-$C_{20}$ alicyclic hydrocarbon skeleton. Examples of the dialcohol having an alicyclic hydrocarbon skeleton include alicyclic dialcohols such as 1,3-cyclopentanediol, 1,3-cyclopentanedimethanol, 1,4-cyclohexanediol, 1,4-cyclohexanedimethanol, 1,4-cycloheptanediol, and 1,4-cycloheptanedimethanol. Among these compounds, from the viewpoint of heat resistance, water absorption properties, availability, and the like, the component unit derived from a dialcohol having a cyclohexane skeleton is preferred, and the component unit derived from cyclohexanedimethanol is more preferred.

While the alicyclic dialcohol contains isomers having a cis/trans configuration or the like, the trans configuration is preferred from the viewpoint of heat resistance. Accordingly, the cis/trans ratio is preferably 50/50 to 0/100, and more preferably 40/60 to 0/100.

The polyester resin (A1) may contain the aliphatic dialcohol component unit (a-4) derived from an aliphatic dialcohol, in addition to the alicyclic dialcohol component unit (a-3), for example, for the purpose of enhancing the melt-flowability of a resin. The aliphatic dialcohol may be, for example, ethylene glycol, trimethylene glycol, propylene glycol, tetramethylene glycol, neopentyl glycol, hexamethylene glycol, or dodecamethylene glycol.

The polyester resin (A1) may further contain an aromatic dialcohol component unit (a-2) as necessary, in addition to the alicyclic dialcohol component unit (a-3). Examples of the aromatic dialcohol include aromatic diols such as bisphenol, hydroquinone, and 2,2-bis(4-(3-hydroxyethoxyphenyl)propanes.

The melting point (Tm) or glass transition temperature (Tg) of the polyester resin (A) measured with a differential scanning calorimeter (DSC) is 250°C or more. The lower limit of the melting point (Tm) or glass transition temperature (Tg) is preferably 270°C, and more preferably 290°C. On the other hand, an example of a preferred upper limit of the melting point (Tm) or glass transition temperature (Tg) is 350°C, and is more preferably 335°C. When the melting point or glass transition temperature is 250°C or more, the deformation of the reflector (molded article of resin composition) during reflow soldering is suppressed. While the upper limit temperature is not limited in principle, the melting point or glass transition temperature of 350°C or lower is preferable because the decomposition of the polyester resin is suppressed during melt molding.

For example, the melting point (Tm) or glass transition temperature (Tg) of the polyester resin (A) is within a range of from 270 to 350°C, and more preferably within a range of from 290 to 335°C.

The intrinsic viscosity [η] of the polyester resin (A) is preferably 0.3 to 1.0 dl/g. When the intrinsic viscosity is in such a range, the flowability of the polyester resin composition for a reflective material during molding is excellent. The intrinsic viscosity of the polyester resin (A) may be adjusted, for example, by adjusting the molecular weight of the polyester resin (A). For adjusting the molecular weight of the polyester resin, use can be made of a known method, such as adjusting the degree of progress in a polycondensation reaction or adding a suitable amount of a monofunctional carboxylic acid, a monofunctional alcohol, or the like

The above-mentioned intrinsic viscosity is a value obtained by dissolving the polyester resin (A) in a 50 mass %/50 mass % mixed solvent of phenol and tetrachloroethane to obtain a sample solution, measuring the falling time (seconds) of the sample solution using an Ubbelohde viscometer under a condition of 25°C±0.05°C, and calculating the intrinsic viscosity from the following equations:

$$[\eta] = \eta SP/[C(1 + k\eta SP)]$$

[η]: intrinsic viscosity (dl/g)
ηSP: specific viscosity
C: sample concentration (g/dl)
t: falling time (seconds) of sample solution
t0: falling time (seconds) of a solvent
k: constant (slope determined by plotting solution concentration on the ordinate and ηSP/C on the abscissa, after measuring the specific viscosity of (3 or more) samples having different solution concentrations)

$$\eta SP = (t - t0)/t0$$

The polyester resin composition for a reflective material of the present invention may contain plurality of polyester resins (A) having different physical properties, as necessary.

[Method of Preparing Polyester Resin (A)]

The polyester resin (A) is obtained, for example, by blending a molecular weight modifier, or the like into a reaction system to allow the dicarboxylic acid component unit (a-1) and the alicyclic dialcohol component unit (a-3) to react with each other. As described above, the intrinsic viscosity of the polyester resin (A) may be adjusted by blending a molecular weight modifier, or the like into the reaction system.

As the molecular weight modifier, a monocarboxylic acid and a monoalcohol can be used. Examples of the monocarboxylic acid include a $C_2$-$C_{30}$ aliphatic monocarboxylic acid, an aromatic monocarboxylic acid and an alicyclic monocarboxylic acid. It is noted that the aromatic monocarboxylic acid and the alicyclic monocarboxylic acid may have a substituent in the cyclic structure thereof. Examples of the aliphatic monocarboxylic acid include acetic acid, propionic acid, butyric acid, valeric acid, caproic acid, caprylic acid, lauric acid, tridecyl acid, myristic acid, palmitic acid, stearic acid, oleic acid, and linoleic acid. Further, examples of the aromatic monocarboxylic acid include benzoic acid, toluic acid, naphthalene carboxylic acid, methylnaphthalene carboxylic acid, and phenylacetic acid, and examples of the alicyclic monocarboxylic acid include cyclohexane carboxylic acid.

Such a molecular weight modifier is used in an amount of typically 0 to 0.07 mole, and preferably 0 to 0.05 mole per 1 mole of the total amount of the dicarboxylic acid component units (a-1) in the reaction system for the reaction between the dicarboxylic acid component unit (a-1) and the alicyclic dialcohol component unit (a-3) as described above.

1-2. Glass Fiber (B)

The glass fiber (B) contained in the polyester resin composition for a reflective material of the present invention imparts strength, rigidity and toughness to a molded article to be obtained. In particular, thinner glass fiber (B) can impart sufficient mechanical properties, in particular thin wall-bending strength to a reflective material which is a molded article. In addition, it is possible to suppress the shrinkage of the reflective material which is a molded article.

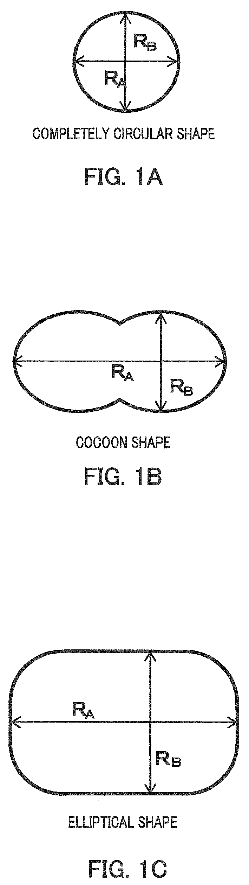

Here, the cross-sectional shape of the glass fiber (B) is not particularly limited, and may assume any shape of true circular shape, elliptical shape, cocoon shape, rectangular shape, or the like. The cross-section of the glass fiber (B) is defined as a cross-section of a glass fiber observed by cutting a glass fiber in a direction perpendicular to the lengthwise direction of the glass fiber. From the viewpoints of the flowability of the polyester resin composition, the low warpage of a molded article to be obtained, and the like, the cross-sectional shape of the glass fiber (B) is preferably a cocoon shape or rectangular shape. FIG. 1 illustrates the cross-sectional shape of glass fibers. FIG. 1(a), 1(b) and 1(c) illustrate the cross-sectional shapes of true circular shape, cocoon shape and substantially rectangular shape, respectively.

The minor axis of the cross-section of the glass fiber (B) contained in the polyester resin composition for a reflective material is preferably 3μm to 8 μm. When the minor axis is 8 μm or less, sufficient mechanical properties can be imparted to the reflective material which is a molded article. In addition, when the minor axis is 3 μm or more, the strength of the glass fiber itself is secured, making the glass fiber (B) less likely to be broken during the resin-molding process of the polyester resin composition for a reflective material.

Here, the major axis and the minor axis of the cross-section of the glass fiber (B) are determined as described below. A resin component is removed from the polyester resin composition for a reflective material containing the glass fiber (B) or from the molded article containing the glass fiber (B) either by dissolving the resin component with a solvent, or by calcination of the composition or the molded article, to thereby separate the glass fiber (B). The cross-sectional shape of the separated glass fiber (B) is observed using an optical microscope or an electron microscope.

Next, an arbitrary point is selected from the outer periphery of the cross section of the glass fiber (B) observed under the above-mentioned optical microscope, and a circumscribing line that circumscribes the selected point is drawn. Then, another circumscribing line which is parallel to the first circumscribing line is drawn, and the distance between these circumscribing lines is measured. These steps are performed for the entire outer periphery of the cross-section of the glass fiber (B), and the shortest distance between the two circumscribing lines is set as the minimum diameter (also referred to as minor axis ($R_B$)), and the longest distance is set as the maximum diameter (also referred to as major axis ($R_A$)).

Here, the irregular shape ratio of the fiber cross-section of the glass fiber (B) contained in the polyester resin composition for a reflective material is preferably 3 to 8, and more preferably 3 to 5. The irregular shape ratio is a ratio ($R_A/R_B$) between the major axis ($R_A$) and the minor axis ($R_B$) of the glass fiber cross-section. The glass fiber (B) having an irregular shape ratio of the fiber cross-section of 3 or more is preferred, because it allows the shrinkage of the reflective material which is a molded article to be effectively suppressed. The glass fiber (B) having an irregular shape ratio of the fiber cross-section of 8 or less is preferred, because it enables stable granulation of the resin composition with a twin-screw extruder or the like.

In addition, the cross-sectional shape (minor axis) and the irregular shape ratio of the glass fiber (B) are preferably not changed due to heat or the like during molding of the polyester resin composition for a reflective material. That is, the cross-sectional shape (minor axis) and the irregular shape ratio of the molded article are preferably also within the above-mentioned ranges. Specifically, the minor axis of the fiber cross-section is preferably 3μm to 8 μm; and the irregular shape ratio is preferably 3 to 8, and more preferably 3 to 5. Excessively small minor axis of the glass fiber (B) in the molded article leads to insufficient rigidity of the molded article.

The major axis and the minor axis of the glass fiber (B) contained in the molded article of the polyester resin composition for a reflective material are measured, for example, by cutting out a part of the molded article by beam processing and by observing the cut-out part of the molded article using a scanning electron microscope (S-4800 manufactured by Hitachi, Ltd.). It is noted that one example of the method of measuring the minor axis and the irregular shape ratio is, for example, a measuring method in which a resin composition is injection molded and observing the obtained molded article having a thickness of 0.5 mm and a size of width 30 mm × length 30 mm.

Here, the average length of the glass fiber (B) contained in the polyester resin composition for a reflective material is typically within a range of from 0.1 to 20 mm, and preferably from 0.3 to 6 mm. The length of 0.1 mm or more is preferred because it can impart sufficient mechanical properties to the molded article.

While the polyester resin composition for a reflective material of the present invention is formed into a reflective material through molding, the polyester resin composition for a reflective material may sometimes be compounded as a material for molding. Compounding is performed typically by kneading and extruding the resin composition. However, kneading and extruding the resin composition containing glass fibers sometimes undesirably causes the glass fibers to be broken. In particular, the polyester resin composition for a reflective material of the present invention contains the glass fiber (B) in which a minor axis of the fiber cross-section is 3 $\mu$m to 8 $\mu$m. That is, the polyester resin composition for a reflective material of the present invention contains the glass fiber (B) whose minor axis of the fiber cross-section is relatively small. Therefore, there has been a concern that the glass fiber (B) is likely to be broken when compounding the resin composition. When the glass fiber (B) is broken, the mechanical strength of the reflective material which is a molded article is not sufficiently enhanced.

To such problems, the polyester resin composition for a reflective material of the present invention inhibits the breakage of the glass fiber (B) by adjusting the content of the olefin polymer (D), as described below. That is, since the olefin polymer (D) has high viscosity, a high olefin polymer (D) content of the composition causes an increase in the viscosity of the polyester resin composition for a reflective material, thereby making the glass fiber (B) to be broken easily. On the other hand, it is considered that a small amount of the olefin polymer (D) blended into the composition functions as a cushioning material (protective material), thus inhibiting the breakage of the glass fiber (B).

The glass fiber (B) may be treated with a silane coupling agent, titanium coupling agent, or the like. For example, the glass fiber (B) may be surface-treated with a silane compound such as vinyltriethoxysilane, 2-aminopropyltriethoxysilane, or 2-glycidoxypropyltriethoxysilane.

The glass fiber (B) is produced according to a known glass fiber production method, and may be coated with a sizing agent for enhancing adhesiveness with respect to the resin, as well as uniform dispersibility. Examples of the preferred sizing agent include acrylic, acrylic/maleic-modified, epoxy, urethane, urethane/maleic-modified, and urethane/epoxy-modified compounds. The sizing agent may be used singly, or in combination.

Further, the glass fiber (B) may be treated with a surface treating agent and a sizing agent in combination. The combined use of the surface treating agent and the sizing agent increases the bonding between the fibrous filler inside the composition and other components inside the composition of the present invention, thus enhancing appearance and strength property.

The glass fiber (B) is preferably dispersed uniformly in the polyester resin composition for a reflective material, and is also preferably dispersed uniformly in the reflective material which is a molded article. The uniform dispersion of the glass fiber (B) in the polyester resin composition for a reflective material increases granularity, thus enhancing the mechanical properties of the molded article as well.

1-3. White Pigment (C)

The white pigment (C) contained in the polyester resin composition for a reflective material of the present invention may be any white pigment that can whiten the resin composition to enhance a light-reflective function, when being used in combination with the polyester resin (A). Specific examples thereof include titanium oxide, zinc oxide, zinc sulfide, lead white, zinc sulfate, barium sulfate, calcium carbonate, and alumina oxide. The polyester resin composition for a reflective material may contain either only one of these white pigments or two or more thereof. In addition, these white pigments may be those treated with a silane coupling agent, titanium coupling agent, or the like. For example, the white pigment may be surface-treated with a silane compound such as vinyltriethoxysilane, 2-aminopropyltriethoxysilane, or 2-glycidoxypropyltriethoxysilane.

The white pigment (C) is particularly preferably titanium oxide. When the polyester resin composition for a reflective material contains titanium oxide, optical properties such as the reflectance and the concealability of a molded article to be obtained are enhanced. The titanium oxide is preferably a rutile-type titanium oxide. The particle diameter of the titanium oxide is preferably 0.1 to 0.5 $\mu$m, and more preferably 0.15 to 0.3 $\mu$m.

The white pigment (C) is preferably a white pigment having a small aspect ratio, i.e., having an approximately spherical shape, for the purpose of uniformizing the reflectance.

1-4. Olefin Polymer (D)

The olefin polymer (D) contained in the polyester resin composition for a reflective material of the present invention is an olefin polymer having a polyolefin unit and a functional group structural unit. Examples of a functional group contained in the functional group structural unit include a functional group containing hetero atoms and an aromatic hydrocarbon group. The olefin polymer (D) is preferably a thermoplastic resin having a polyolefin unit, and a structural unit containing a hetero atom-containing functional group (functional group structural unit).

The hetero atom is preferably oxygen, and the hetero atom-containing functional group preferably contains carbon, hydrogen and oxygen. Specific examples of the functional groups containing such hetero atoms can include an ester group, an ether group, a carboxylic acid group (including carboxylic anhydride group), an aldehyde group, and a ketone group.

The olefin polymer (D) contains 0.2 to 1.8% by mass of the functional group structural unit per 100% by mass of the olefin polymer (D). The content of the functional group structural unit contained in the olefin polymer (D) is more preferably 0.2 to 1.2% by mass. Too low content of the functional group structural unit may sometimes result in poor enhancement of the toughness of the resin composition to be described hereinafter. It is presumed that the reason for this is because too weak interaction between the olefin polymer (D) and the polyester resin (A) makes the olefin polymer (D) likely to aggregate.

On the other hand, too large content of the functional group structural unit causes the interaction with respect to the polyester resin (A) to be too strong, which lowers melt-flowability, thus sometimes resulting in the lowering of moldability. In addition, the too large content of the functional group causes coloration as a result of denaturation, or the like due to heat or light, which may sometimes result in the lowering of the stability of reflectance over time. Aside from these problems, when multiple functional group structural units are introduced into the olefin polymer, unreacted functional group-containing compounds tend to remain, and these unreacted compounds may also sometimes accelerate the above-mentioned problem of denaturation (such as coloration).

The content of the functional group structural unit in the olefin polymer (D) is specified from the charging ratio for the reaction between the olefin polymers and the functional group-containing organic compounds in the presence of a radical initiator, or by known means such as $^{13}C$ NMR measurement and $^{1}H$ NMR measurement. The following conditions can be exemplified as specific NMR measurement conditions.

In the case of $^{1}H$ NMR measurement, use can be made of an ECX400-type nuclear magnetic resonance apparatus manufactured by JEOL Ltd. under the following conditions: deuterated orthodichlorobenzene as a solvent, a sample concentration of 20 mg/0.6 mL, a measurement temperature of 120°C, an observation nucleus of $^{1}H$ (400 MHz), a sequence of a single pulse, a pulse width of 5.12 $\mu$seconds (45° pulse), a repetition time of 7.0 seconds, and an integration count of 500 times or more. According to the reference chemical shift, hydrogen of tetramethylsilane is set at 0 ppm, but similar results can be also obtained, for example, by setting the peak derived from residual hydrogen of deuterated orthodichlorobenzene at 7.10 ppm and using as the reference value of the chemical shift. It is noted that the peak for $^{1}H$ or the like derived from a functional group-containing compound is assigned by a conventional method.

On the other hand, in the case of $^{13}C$ NMR measurement, use can be made of an ECP500-type nuclear magnetic resonance apparatus manufactured by JEOL Ltd. under the following conditions: a mixed solvent of orthodichlorobenzene/deuterated benzene (80/20 viol.%) as a solvent, a measurement temperature of 120°C, an observation nucleus of $^{13}C$ (125 MHz), single pulse proton decoupling, a 45° pulse, a repetition time of 5.5 seconds, an integration count of 10,000 times or more, and using 27.50 ppm as a reference value of the chemical shift. Assignment of various signals can be carried out based on a conventional method, and can be quantified based on the integrated value of signal strength.

As another simple method for determining the content ratio of functional group structural units, it is also possible to determine in advance the functional group content ratio of polymers each having a different functional group content ratio by the above NMR measurement; carry out infrared spectroscopy (IR) measurement of these polymers; prepare a calibration curve based on the intensity ratio of a specific peak; and determine the functional group structural unit content ratio based on this result. This method is simple as compared with the NMR measurement described above, but it is basically necessary to prepare respectively corresponding calibration curves depending on the types of base resins or functional groups. For these reasons, this method is preferably used, for example, for the process control in the resin production in a commercial plant.

On the other hand, the skeleton of the olefin polymer (D) is preferably a structure derived from a polyolefin; preferred examples thereof include known olefin polymer skeletons such as ethylenic polymers, propylene polymers, butene polymers and copolymers of these olefins. Particularly preferred olefin polymer skeleton is a copolymer of ethylene and an olefin having 3 or more carbon atoms.

The olefin polymer (D) can be obtained, for example, by reacting a corresponding known olefin polymer with a compound containing a corresponding functional group at a specific ratio. One preferred example of the olefin polymer is an ethylene·$\alpha$-olefin copolymer. Hereinafter, description will be made of the case of using the ethylene·$\alpha$-olefin copolymer as an olefin polymer.

The above-mentioned ethylene·$\alpha$-olefin copolymer (before reacting with the compound containing the functional group) is a copolymer of ethylene and other olefins, for example, $C_3$-$C_{10}$ $\alpha$-olefins such as propylene, 1-butene, 1-hexene, 4-methyl-1-pentene, 1-octene, and 1-decene. Specific examples of the ethylene·$\alpha$-olefin copolymer include ethylene·propylene copolymer, ethylene·1-butene copolymer, ethylene·1-hexene copolymer, ethylene·1-octene copolymer, and ethylene·4-methyl-1-pentene copolymer. Among those, ethylene·propylene copolymer, ethylene·1-butene copolymer, ethylene· 1-hexene copolymer, and ethylene· 1-octene copolymer are preferred.

In the ethylene· $\alpha$-olefin copolymer, a structural unit derived from ethylene is 70 to 99.5% by mole, and preferably 80 to 99% by mole, whereas a structural unit derived from $\alpha$-olefin is 0.5 to 30% by mole, and preferably 1 to 20% by mole.

The ethylene·$\alpha$-olefin copolymer is preferably an ethylene·$\alpha$-olefin copolymer having a melt flow rate (MFR) of 0.01 to 20 g/10 minutes, and preferably 0.05 to 20 g/10 minutes, measured according to ASTM D1238 at 190°C and at a load of 2.16 kg.

The method of producing the ethylene·$\alpha$-olefin copolymer is not particularly limited, and can be prepared according to a known method, for example, using a transition metal catalyst such as a titanium (Ti), vanadium (V), chrome (Cr), or zirconium (Zr) catalyst. More specific example thereof can be a method of producing the copolymer by copolymerizing ethylene and at least one $C_3$-$C_{10}$ $\alpha$-olefin in the presence of Ziegler type catalyst composed of a vanadium (V) compound and an organoaluminum compound, or a metallocene catalyst. A production method of using a metallocene catalyst is particularly suitable.

Preferred examples of the functional group-containing compound to be reacted with the olefin polymer include unsaturated carboxylic acids or derivatives thereof. Specific examples thereof include unsaturated carboxylic acids such as acrylic acid, methacrylic acid, $\alpha$-ethylacrylic acid, maleic acid, fumaric acid, itaconic acid, citraconic acid, tetrahydrophthalic acid, methyl tetrahydrophthalic acid, and endo-cis-bicyclo[2,2,1]hept-5-ene-2,3-dicarboxylic acid (Nadic acid [trademark]), and derivatives thereof such as acid halides, amides, imides, acid anhydrides, and esters. Among those, unsaturated dicarboxylic acids or acid anhydrides thereof are suitable, and maleic acid, Nadic acid (trademark), or acid anhydrides thereof are particularly suitable.

Particularly preferred examples of the functional group-containing compounds can include maleic acid anhydride. The maleic acid anhydride has relatively high reactivity with the olefin polymer, with less major structural change in itself caused by polymerization or the like, and tends to have a stable fundamental structure. Therefore, the maleic acid anhydride has various advantages such as obtainment of the olefin polymer (D) with stable quality.

One example of the method of obtaining the olefin polymer (D) using the ethylene·$\alpha$-olefin copolymer is a method of subjecting the ethylene·$\alpha$-olefin copolymer to so-called graft modification with a functional group-containing compound corresponding to a functional group structural unit.

The graft modification of the ethylene·$\alpha$-olefin copolymer can be conducted by a known method. An example thereof can be a method in which the ethylene·$\alpha$-olefin copolymer is dissolved in an organic solvent, followed by addition of an unsaturated carboxylic acid or a derivative thereof, a radical initiator, and the like to the resultant solution, and the resultant mixture is allowed to react at a temperature of typically 60 to 350°C, and preferably 80 to 190°C, for 0.5 to 15 hours, and preferably for 1 to 10 hours.

The above organic solvent is not particularly limited as long as the organic solvent is an organic solvent that can dissolve the ethylene·$\alpha$-olefin copolymer. Examples of such an organic solvent include aromatic hydrocarbon solvents such as benzene, toluene and xylene; and aliphatic hydrocarbon solvents such as pentane, hexane and heptane.

Examples of other graft modification methods include a method in which an extruder or the like is used for reacting an ethylene·$\alpha$-olefin copolymer with an unsaturated carboxylic acid or a derivative thereof, preferably without using a solvent. As for the reaction conditions in this case, the reaction temperature can typically be equal to or higher than the melting point of the ethylene· $\alpha$-olefin copolymer, and specifically 100 to 350°C. The reaction time can typically be 0.5 to 10 minutes.

In order to efficiently subject the functional group-containing compound such as the unsaturated carboxylic acid to graft copolymerization, the reaction is preferably carried out in the presence of a radical initiator.

Examples of the radical initiator to be used include organic peroxides and organic peresters, such as benzoyl peroxide, dichlorobenzoyl peroxide, dicumyl peroxide, di-t-butyl peroxide, 2,5-dimethyl-2,5-di(peroxide benzoate)hexyne-3,1,4-bis(t-butylperoxyisopropyl)benzene, lauroyl peroxide, t-butyl peracetate, 2,5-dimethyl-2,5-di(t-butylperoxy)hexyne-3,2,5-dimethyl-2,5-di(t-butylperoxy)hexane, t-butyl perbenzoate, t-butyl perphenylacetate, t-butyl perisobutyrate, t-butyl per-sec-octoate, t-butyl perpivalate, cumyl perpivalate, and t-butyl perdiethylacetate; and azo compounds such as azobisisobutyronitrile and dimethyl azoisobutyrate. Among these, dialkyl peroxides, such as dicumyl peroxide, di-t-butyl peroxide, 2,5-dimethyl-2,5-di(t-butylperoxy)hexyne-3,2,5-dimethyl-2,5-di(t-butylperoxy)hexane, and 1,4-bis(t-butylperoxyisopropyl)benzene are preferred. A radical initiator is typically used in a ratio of from 0.001 to 1 part by mass per 100 parts by mass of the ethylene· $\alpha$-olefin copolymer before modification.

The density of the modified ethylene·$\alpha$-olefin copolymer is preferably 0.80 to 0.95 g/cm$^3$, and more preferably 0.85 to 0.90 g/cm$^3$.

Further, the intrinsic viscosity [$\eta$] of the modified ethylene·$\alpha$-olefin copolymer as measured in its decalin (decahydronaphthalene) solution at 135°C is preferably 1.5 to 4.5 dl/g, and more preferably 1.6 to 3 dl/g. When [$\eta$] is within the above-mentioned range, the resin composition of the present invention can achieve both toughness and melt-flowability at a high level.

The intrinsic viscosity [$\eta$] of the olefin polymer (D) in decalin at 135°C is measured based on a conventional method as follows. 20 mg of a sample is dissolved in 15 ml of decalin, and the specific viscosity ($\eta$sp) is measured in a 135°C atmosphere using an Ubbelohde viscometer. The thus obtained decalin solution is diluted by further adding 5 ml of decalin, and a similar specific viscosity measurement is carried out. This dilution operation and viscosity measurement are further repeated twice, and based on the resultant measurements, the intrinsic viscosity [$\eta$] is defined as the "$\eta$sp/C"

value when the concentration (C) is extrapolated to zero.

### 1-5. Other Additives

The polyester resin composition for a reflective material of the present invention may contain, for example, the following arbitrary additives, depending on applications, as long as the effect of the present invention is not impaired: antioxidants (such as phenols, amines, sulfur, and phosphorus), heat-resistant stabilizers (such as lactone compounds, vitamin E, hydroquinones, copper halides, and iodine compounds), light stabilizers (such as benzotriazoles, triazines, benzophenones, benzoates, hindered amines, and oxanilides), other polymers (such as polyolefins, ethylene·propylene copolymers, olefin copolymers such as an ethylene·1-butene copolymer, olefin copolymers such as a propylene·1-butene copolymer, polystyrene, polyamide, polycarbonate, polyacetal, polysulfone, polyphenylene oxide, fluororesins, silicone resins, and LCP), flame retardants (such as bromine-based, chlorine-based, phosphorus-based, antimony-based, or inorganic flame retardants), fluorescent brightening agents, plasticizers, thickeners, antistatic agents, release agents, pigments, crystal nucleating agents, and various known compounding agents.

In particular, the polyester resin composition for a reflective material of the present invention may contain a phosphorus-containing antioxidant. The phosphorus-containing antioxidant is preferably an antioxidant having a $P(OR)_3$ structure. Here, R is an alkyl group, alkylene group, aryl group, arylene group, or the like, and three Rs may be different, or two Rs may form a cyclic structure. Examples of the phosphorus-containing antioxidant include triphenyl phosphite, diphenyl decyl phosphite, phenyl diisodecyl phosphite, tri(nonylphenyl) phosphite, bis(2,4-di-t-butylphenyl) pentaerythritol diphosphite, and bis(2,6-di-t-butyl-4-methylphenyl) pentaerythritol diphosphite. When the phosphorus-containing antioxidant is contained, the decomposition reaction of a polyester is suppressed in a high temperature atmosphere (in particular, under conditions exceeding 250°C as in the reflow process). As a result, advantages, such as suppression of the coloration of the composition are achieved.

The additive content is preferably 0 to 10% by mass per 100% by mass of the total of the polyester resin (A) and the olefin polymer (D), more preferably 0 to 5% by mass, and even more preferably 0 to 1% by mass, although it varies depending on the type of the components.

When the resin composition of the present invention is used in combination with other components, selection of the above additives may become important at times. For example, when other component to be used in combination includes a catalyst, it is preferred to avoid the use as an additive a compound containing a component or an element that can be a catalyst poison. Examples of the additives that are preferably avoided include compounds containing sulfur, or the like.

### 1-6. Inorganic Filler

The polyester resin composition for a reflective material of the present invention may contain an inorganic filler other than the glass fiber (B). The inorganic filler may be known inorganic fillers, or the like. Specifically, the inorganic fillers are preferably various inorganic reinforcing materials of a shape having a high aspect ratio such as a fibrous, powdery, granular, tabular, needle-like, cloth-like, and mat-like shape. Specific examples include glass fibers other than the glass fiber (B), inorganic compounds having a carbonyl structure (such as the whisker of carbonate such as calcium carbonate), hydrotalcite, titanates such as potassium titanate, Wollastonite, and xonotlite.

The average length of the inorganic filler is in the range of, for example, 10 μm to 10 mm, preferably 10 μm to 5 mm, more preferably 10 to 100 μm, and even more preferably 10 to 50 μm. The aspect ratio (average fiber length L/average fiber diameter D) is in the range of, for example, 1 to 500, preferably 1 to 350, more preferably 1 to 100, and even more preferably 5 to 70. The use of an inorganic filler in such a range is preferred in terms of improvement in strength, lowering of a coefficient of linear thermal expansion, and the like.

As the inorganic filler, two or more inorganic fillers having different lengths and different aspect ratios may be used in combination.

Specific examples of the inorganic fillers having a large length or aspect ratio can include the above-mentioned glass fibers, silicates such as Wollastonite (calcium silicate), and titanates such as a potassium titanate whisker. Among those, the glass fiber is preferred.

The lower limit of preferred length (fiber length) of such an inorganic filler having a large length or aspect ratio is 15 μm, preferably 30 μm, and more preferably 50 μm. On the other hand, the upper limit thereof is preferably 10 mm, more preferably 8 mm, even more preferably 6 mm, and particularly preferably 5 mm. Particularly in the case of the glass fiber, the lower limit is preferably 500 μm, more preferably 700 μm, and even more preferably 1 mm.

The lower limit of the aspect ratio of such an inorganic filler having a large length or aspect ratio is preferably 20, more preferably 50, and even more preferably 90. On the other hand, the upper limit thereof is preferably 500, more preferably 400, and even more preferably 350.

Preferred examples of an inorganic filler having a relatively small length or aspect ratio include an inorganic filler (BW) having a carbonyl group, and specific examples thereof can include whiskers of carbonates such as calcium carbonate.

The aspect ratio of the inorganic filler having a carbonyl group is preferably 1 to 300, more preferably 5 to 200, and even more preferably 10 to 150.

The combined use of these inorganic fillers is considered to improve the dispersibility of the inorganic filler in the base polymer. Further, enhanced affinity between the base polymer and the inorganic filler is considered to enhance not only heat resistance, mechanical strength, and the like, but also at times enhances the dispersibility of the white pigment (C).

1-7. Composition of Polyester Resin Composition for Reflective Material

The polyester resin composition for a reflective material of the present invention contains the polyester resin (A) at a ratio of preferably 30 to 80% by mass, more preferably 30 to 70% by mass, and even more preferably 40 to 60% by mass to the total amount (100% by mass) of the polyester resin (A), the glass fiber (B), the white pigment (C) and the olefin polymer (D). When the content of the polyester resin (A) is in the above-mentioned range, it is possible to obtain a polyester resin composition for a reflective material having excellent heat resistance capable of resisting a soldering reflow process without impairing moldability.

The polyester resin composition for a reflective material of the present invention contains the glass fiber (B) at a ratio of preferably 10 to 35% by mass, more preferably 10 to 30% by mass, and even more preferably 10 to 25% by mass to the total amount (100% by mass) of the polyester resin (A), the glass fiber (B), the white pigment (C) and the olefin polymer (D). When the glass fiber (B) is contained at a ratio of 10% by mass or more, a molded article is not deformed during injection molding or a soldering reflow process, and the stability of reflectance over time tends to be excellent. In addition, when the glass fiber (B) is contained at a ratio of 35% by mass or less, it is possible to obtain a molded article having satisfactory moldability and appearance.

The polyester resin composition for a reflective material of the present invention contains the white pigment (C) at a ratio of preferably 5 to 50% by mass, more preferably 10 to 50% by mass, and even more preferably 10 to 40% by mass to the total amount (100% by mass) of the polyester resin (A), the glass fiber (B), the white pigment (C) and the olefin polymer (D). When the content of the white pigment (C) is 5% by mass or more, it is possible to obtain sufficient light reflectance characteristics, such as reflectivity. In addition, the ratio of 50% by mass or less is preferred, because moldability is not impaired.

The polyester resin composition for a reflective material of the present invention contains the olefin polymer (D) at a ratio of preferably 0.3 to 1.5% by mass, more preferably 0.5 to 1.3% by mass, and even more preferably 0.5 to 1.1% by mass to the total amount (100% by mass) of the polyester resin (A), the glass fiber (B), the white pigment (C) and the olefin polymer (D).

When the content ratio of the olefin polymer (D) is 1.5% by mass or less, the olefin polymer (D) is dispersed uniformly in the polyester resin composition for a reflective material, thus obtaining a composition without uneven viscosity. Therefore, it is possible to impart high heat resistance as well as high toughness to a reflective material which is a molded article without impairing the stability of reflectance over time. Further, when the content ratio of the olefin polymer (D) is 0.3% by mass or more, the olefm polymer (D) can function as a protective material (cushioning material) of the glass fiber (B), thereby inhibiting the glass fiber (B) from being broken. As a result, the reflective material which is a molded article is likely to exhibit toughness and heat resistance as well as high reflectance stably over time.

2. Method of Producing Polyester Resin Composition for Reflective Material

The polyester resin composition for a reflective material of the present invention can be produced by a known method, for example, a method in which the above components are mixed with a Henschel mixer, a V-blender, a ribbon blender, a tumbler blender, or the like, or a method in which, after the mixing, the mixture is further melt-kneaded with a single-screw extruder, a multi-screw extruder, a kneader, a Banbury mixer, or the like and then granulated or ground.

3. Application of Polyester Resin Composition for Reflective Material

The reflector of the present invention is a molded article molded into an arbitrary shape from the above-mentioned polyester resin composition for a reflective material. The polyester resin composition for a reflective material is excellent in flowability and moldability. The reflector of the present invention has high mechanical strength, excellent heat resistance, high reflectance and less lowering of reflectance over time, and thus is suitable as reflectors for various applications. The reflector of the present invention is particularly suitable as a reflector to deflect a beam from a light source such as a semiconductor laser or a light-emitting diode.

The reflector typically includes a casing or housing of which a surface in the direction in which at least light is emitted is open or not open. More specifically, the reflector also includes a three-dimensional molded article, in general, having a light-reflecting surface (a surface such as a planar surface, a spherical surface, or a curved surface), such as molded articles including a box-like or case-like molded article, a funnel-like molded article, a bowl-like molded article, a parabolic molded article, a cylindrical molded article, a conical molded article, and a honeycomb molded article.

Since the reflector obtained by using the polyester resin composition for a reflective material of the present invention is excellent in heat resistance, the stability of reflectance over time, and further in toughness, even a thin reflector is considered to have high possibility of having sufficient strength. Therefore, the reflector is expected to contribute to the weight reduction and miniaturization of an LED element, or the like.

The application of the reflector of the present invention most preferably includes a reflector for a light-emitting diode (LED) element. The reflector for the light-emitting diode element of the present invention is obtained by shaping the polyester resin composition for a reflective material into a desired shape by hot forming such as injection molding, particularly insert molding of metal such as hoop molding, melt molding, extrusion molding, inflation molding, and blow molding. In addition, a light-emitting diode element can be obtained by mounting an LED element and other parts to the reflector, followed by sealing with a sealing resin, joining, bonding, and the like.

Further, the polyester resin composition for a reflective material and the reflector of the present invention can be adapted not only to the LED application, but also to other applications for reflecting a beam. As specific examples, the reflector of the present invention can be used as a reflector for light-emitting apparatuses, such as various electric electronic components, interior illumination, ceiling illumination, exterior illumination, automobile illumination, display equipment, and headlights.

Examples

Hereinafter, the present invention is described with reference to Examples, which however shall not be construed as limiting the technical scope of the present invention.

In each Example and Comparative Example, the following components were used:

(1) Polyester resin (A): use was made of the polyester resin (A) prepared according to the method described below.
(2) Glass fiber (B)

· Glass fiber (B1): a length of 3 mm, a completely circular fiber cross-section with a minor axis of 6 $\mu$m, and an aspect ratio (average fiber length/average fiber diameter) of 500 (ECS03T-790DE manufactured by Nippon Electric Glass Co., Ltd.)
· Glass fiber (B2): a length of 3 mm, a fiber cross-section with a minor axis of 7 $\mu$m and a major axis of 28 $\mu$m, an irregular shape ratio (major axis/minor axis) of 4, and an aspect ratio (average fiber length/average fiber diameter) of 430 (CSG 3PA-830, a product treated with a silane compound, manufactured by Nitto Boseki Co., Ltd.)
· Glass fiber (B3): a length of 3 mm, a completely circular fiber cross-section with a minor axis of 9 $\mu$m, and an aspect ratio (average fiber length/average fiber diameter) of 300 (ECS03-615, a product treated with a silane compound, manufactured by Central Glass Co., Ltd.)

(3) White pigment (C): titanium oxide (powder, average particle diameter: 0.21 $\mu$m)
(4) Olefin polymer (D): the olefin polymers (D1) to (D3) or ethylene· 1-butene copolymer (D') prepared according to the methods described below were used.
(5) Antioxidant (E): ADK STAB PEP-36 (Adeka Corporation)

(Method of Preparing Polyester Resin (A))

To a mixture of 106.2 parts of dimethyl terephthalate and 94.6 parts of 1,4-cyclohexanedimethanol (cis/trans ratio: 30/70) was added 0.0037 part of tetrabutyl titanate, and the temperature was raised from 150 to 300°C over 3 hours and 30 minutes to effect an ester exchange reaction.

At the completion of the above ester exchange reaction, 0.066 part of magnesium acetate tetrahydrate dissolved in 1,4-cyclohexanedimethanol was added thereto, followed by an introduction of 0.1027 part of tetrabutyl titanate for effecting a polycondensation reaction. During the polycondensation reaction, the pressure was gradually reduced from normal pressure to 1 Torr over 85 minutes, and at the same time, the temperature was raised to a predetermined polymerization temperature of 300°C. The reaction mixture was stirred continuously while maintaining the temperature and the pressure, and the reaction was terminated when a predetermined stirring torque was reached. Then, the thus produced polymer was taken out from the reaction mixture.

Further, the polymer was subjected to solid phase polymerization at 260°C and 1 Torr or less for 3 hours. The resultant polymer (polyester resin (A)) had an intrinsic viscosity [η] of 0.6 dl/g and a melting point of 290°C.

(Method of Preparing Olefin Polymer (D1))

[Preparation of Catalytic Solution]

Into a glass flask sufficiently purged with nitrogen was fed 0.63 mg of bis(1,3-dimethylcyclopentadienyl)zirconium dichloride, followed by further addition of 1.57 ml of a toluene solution of methylaminoxane (Al; 0.13 millimole/liter) and 2.43 ml of toluene to thereby obtain a catalytic solution.

(Preparation of Ethylene-1-Butene Copolymer (D'))

Into a stainless autoclave having an internal volume of 2 liters sufficiently purged with nitrogen were introduced 912 ml of hexane and 320 ml of 1-butene, and the temperature inside the system was raised to 80°C. 0.9 millimole of triisobutylaluminum and 2.0 ml (0.0005 millimole as Zr) of the catalytic solution prepared as described above were added, followed by injection of ethylene to initiate polymerization. The total pressure was maintained at 8.0 kg/cm$^2$-G by continuously supplying ethylene, and the polymerization was carried out at 80°C for 30 minutes.
A small amount of ethanol was introduced into the system to terminate the polymerization, and then unreacted ethylene was purged. The resultant solution was charged into a large excess of methanol to thereby precipitate a white solid. The white solid was collected by filtration and dried under reduced pressure overnight to obtain a white solid (ethylene· 1-butene copolymer (D')).
Density = 0.862 g/cm$^3$
MFR (ASTM D1238 standard, 190°C, load 2,160 g) = 0.5 g/10 min
Content of 1-butene structural units: 4% by mole
The density of the ethylene·1-butene copolymer (D') was measured as follows. A sheet having a thickness of 0.5 mm was molded at a pressure of 100 kg/cm$^2$ using a hydraulic hot press machine manufactured by SHINTO Metal Industries Corporation set at 190°C (spacer shape: 9 pieces of sheets each having a size of 45×45×0.5 mm (thickness) are produced from a plate having a size of 240×240×0.5 mm). A sample for measurement was prepared by cooling and compressing the molded sheet at a pressure of 100 kg/cm$^2$ by a hydraulic hot press machine manufactured by SHINTO Metal Industries Corporation different from that used above which is set at 20°C. A stainless steel (SUS) plate having a thickness of 5 mm was used as a hot plate. The resultant pressed sheet was heat-treated at 120°C for 1 hour, slowly cooled linearly to room temperature over 1 hour, and then the density was measured with a density gradient tube.

[Preparation of Modified-Ethylene· 1-Butene Copolymer]

0.6 part by mass of maleic anhydride and 0.02 part by mass of peroxide [Perhexyne 25B (trademark), manufactured by NOF Corporation,] were mixed with 100 parts by mass of ethylene·1-butene copolymer (D'), and the resultant mixture was subjected to melt graft modification in a single-screw extruder set at 230°C to thereby obtain a modified-ethylene·1-butene copolymer (olefin polymer (D1)) having the following physical properties. The amount of maleic anhydride graft modification (amount of functional group structural units) of the olefin polymer (D1) was 0.55% by mass. Further, the intrinsic viscosity [η] measured in the form of a decalin solution at 135°C was 1.98 dl/g.
The amount of maleic anhydride graft modification was determined based on $^1$H NMR measurement. The measurement was made using an ECX400-type nuclear magnetic resonance apparatus manufactured by JEOL Ltd. under the following conditions: deuterated orthodichlorobenzene as a solvent, a sample concentration of 20 mg/0.6 mL, a measurement temperature of 120°C, an observation nucleus of $^1$H (400 MHz), a sequence of a single pulse, a pulse width of 5.12 μseconds (45° pulse), a repetition time of 7.0 seconds, and an integration count of 500 times or more. As for the reference chemical shift, the peak derived from residual hydrogen of deuterated orthodichlorobenzene was set at 7.10 ppm. The peak of $^1$H or the like derived from a functional group-containing compound was assigned by a conventional method.

(Preparation of Olefin Polymer (D2))

A modified-ethylene·1-butene copolymer (olefin polymer (D2)) was obtained according to a method similar to the method for preparing the olefin polymer (D1) except that the amount of maleic anhydride to be reacted with the ethylene·1-butene copolymer (D') was changed. The amount (functional group structural unit amount) of graft modification of the modified-ethylene·1-butene copolymer (olefin polymer (D2)) with maleic anhydride was 0.98% by mass. Further, the intrinsic viscosity [η] measured in the form of a decalin solution at 135°C was 2.00 dl/g.

(Preparation of Olefin Polymer (D3))

A modified-ethylene·1-butene copolymer (olefin polymer (D3)) was obtained according to a method similar to the method for preparing the olefin polymer (D1) except that the amount of maleic anhydride to be reacted with the ethylene·1-butene copolymer (D') was changed. The amount (functional group structural unit amount) of graft modification of the modified-ethylene·1-butene copolymer (olefin polymer (D3)) with maleic anhydride was 1.91% by mass. Further, the intrinsic viscosity $[\eta]$ measured in the form of a decalin solution at 135°C was 1.84 dl/g.

[Example 1]

The polyester resin (A), the glass fiber (B1), the white pigment (C), the olefin polymer (D), and the antioxidant (E) were mixed using a tumbler blender at a composition ratio as shown in Table 1. The mixture as a raw material was melt-kneaded in a twin-screw extruder (TEX30$\alpha$ manufactured by Japan Steel Works, Ltd.) at a cylinder temperature of 300°C, and then extruded into a strand shape. The extruded strand was cooled in a water tank, pulled out and cut by a pelletizer, thereby obtaining the composition in a pellet shape. That is, satisfactory compoundability of the composition was confirmed.

[Examples 2 to 8] and [Comparative Examples 1 to 8]

Polyester resins were prepared in the same manner as in Example 1 except that the composition ratios shown in Table 1 were used.

**EP 2 995 648 A1**

[Table 1]

| | | Example 1 | Example 2 | Example 3 | Example 4 | Example 5 | Example 6 | Example 7 | Example 8 | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|---|---|---|---|---|---|---|
| Polyester Resin (A) | Melting Point (°C) | 290 | 290 | 290 | 290 | 290 | 290 | 290 | 290 | 290 | 290 | 290 | 290 | 290 | 290 | 290 | 290 |
| | Added Amount (% by mass) | 68.5 | 58.5 | 53.5 | 68.5 | 58.5 | 58.5 | 59 | 58 | 73.5 | 38.5 | 59.5 | 58.5 | 68.5 | 58.5 | 57.5 | 58.5 |
| Glass Fiber (B) | Type of Glass Fiber | B1 | B1 | B1 | B2 | B2 | B2 | B1 | B1 | B1 | B1 | B1 | B1 | B3 | B3 | B1 | B1 |
| | Minor Axis ($\mu$m) | 6 | 6 | 6 | 7 | 7 | 7 | 6 | 6 | 6 | 6 | 6 | 6 | 9 | 9 | 6 | 6 |
| | Irregular Shape Ratio | 1 | 1 | 1 | 4 | 4 | 4 | 1 | 1 | 1 | 1 | 1 | 1 | 1 | 1 | 1 | 1 |
| | Aspect Ratio | 500 | 500 | 500 | 430 | 430 | 430 | 500 | 500 | 500 | 500 | 500 | 500 | 300 | 300 | 500 | 500 |
| | Added Amount (% by mass) | 10 | 20 | 25 | 10 | 20 | 20 | 20 | 20 | 5 | 40 | 20 | 20 | 10 | 20 | 20 | 20 |
| White Pigment (C) (% by mass) | | 20 | 20 | 20 | 20 | 20 | 20 | 20 | 20 | 20 | 20 | 20 | 20 | 20 | 20 | 20 | 20 |
| Modified-Olefin Polymer (D) | Type of Modified-Olefin Polymer | D1 | D1 | D1 | D1 | D1 | D2 | D1 | D1 | D1 | D1 | - | D' | D1 | D1 | D1 | D3 |
| | Olefin Skeleton* | C2/C4 | C2/C4 | C2/C4 | C2/C4 | C2/C4 | C2/C4 | C2/C4 | C2/C4 | C2/C4 | C2/C4 | - | C2/C4 | C2/C4 | C2/C4 | C2/C4 | C2/C4 |
| | Amount of Functional Group Structural Unit (% by mass) | 0.55 | 0.55 | 0.55 | 0.55 | 0.55 | 0.98 | 0.55 | 0.55 | 0.55 | 0.55 | - | 0 | 0.55 | 0.55 | 0.55 | 1.91 |
| | [$\eta$] (dl/g) | 1.98 | 1.98 | 1.98 | 1.98 | 1.98 | 2 | 1.98 | 1.98 | 1.98 | 1.98 | - | | 1.98 | 1.98 | 1.98 | 1.84 |
| | Added Amount (% by mass) | 1.0 | 1.0 | 1.0 | 1.0 | 1.0 | 1.0 | 0.5 | 1.5 | 1.0 | 1.0 | 0.0 | 1.0 | 1.0 | 1.0 | 2.0 | 1.0 |
| Antioxidant (E) (% by mass) | | 0.5 | 0.5 | 0.5 | 0.5 | 0.5 | 0.5 | 0.5 | 0.5 | 0.5 | 0.5 | 0.5 | 0.5 | 0.5 | 0.5 | 0.5 | 0.5 |

*C2/C4 of the olefin skeleton indicates ethylene·1-butene copolymer.

15

For each polyester resin composition obtained in each example and each comparative example, the following physical properties were evaluated. The results are shown in Table 2.

[Thin Wall Flexural Test]

The resin composition was molded under the following molding conditions using the following injection molding machine to prepare a test piece having a length of 64 mm, a width of 6 mm, and a thickness of 0.8 mm. The test piece was allowed to stand at a temperature of 23°C in a nitrogen atmosphere for 24 hours. Next, the test piece was subjected to flexural test in an atmosphere in which a temperature is 23°C and a relative humidity is 50% using a flexural test machine AB5 manufactured by INTESCO at a span of 26 mm and a flexural rate of 5 mm/min to measure the strength, elastic modulus, and deflection amount of the test piece.

Molding machine: Tuparl TR40S3A by Sodick Plustech Co., Ltd.
Molding machine cylinder temperature: melting point (Tm) + 10°C
Mold temperature: 150°C

[Reflectance: Initial]

The resin composition was injection-molded under the following molding conditions using the following injection molding machine to prepare a test piece having a length of 30 mm, a width of 30 mm, and a thickness of 0.5 mm. The resultant test piece was determined in term of reflectance in the wavelength region from 360 nm to 740 nm using CM3500d manufactured by Minolta Co., Ltd. The initial reflectance was evaluated using the reflectance at 450 nm as a representative value.

Molding machine: SE50DU manufactured by Sumitomo Heavy Industries, Ltd.
Cylinder temperature: melting point (Tm) + 10°C
Mold temperature: 150°C

[Reflectance: After Heating]

The sample with which the initial reflectance was measured was allowed to stand in an oven at 150°C for 336 hours. This sample was measured in terms of reflectance in the same manner as in the initial reflectance, and the resultant reflectance was defined as reflectance after heating.

[Flowability]

A bar-flow mold having a width of 10 mm and a thickness of 0.5 mm was used for the injection molding of the resin composition under the following conditions to measure the flow length (mm) of the resin in the mold.

Injection molding machine: Tuparl TR40S3A by Sodick Plustech Co., Ltd.
Preset injection pressure: 2,000 kg/cm$^2$
Preset cylinder temperature: melting point (Tm) + 10°C
Mold temperature: 30°C.

[Mold Shrinkage Rate]

The resin composition was injection-molded using SE50-type molding machine manufactured by Sumitomo Heavy Industries, Ltd. to prepare at a temperature of 295°C a test piece having a length of 50 mm in the MD direction, a length of 30 mm in the TD direction, and a thickness of 0.6 mm. The temperature of the mold was set at 150°C.

The mold used had concave parts formed by a pair of parallel lines having an interval of 40 mm in the MD direction and a pair of parallel lines having an interval of 20 mm in the TD direction.

The distances in the MD direction and in the TD direction of the above linear part formed in the test piece were measured to determine the shrinkage rate based on the interval between the lines preset by the mold.

[Method of Measuring Irregular Shape Ratio of Glass Fiber (B) in Resin Composition and Molded Article]

The cross-section of the glass fiber (B) to be used for the preparation of the resin composition was observed using a scanning electron microscope (S-4800 manufactured by Hitachi, Ltd.) to calculate the irregular shape ratio of the glass fiber (B). On the other hand, the resin composition was injection-molded to obtain a molded article having a thickness of 0.5 mm (and a size of 30 mm × 30 mm). A part of the molded article was cut out by argon ion beam processing and was observed using a scanning electron microscope (S-4800 manufactured by Hitachi, Ltd.) to calculate the irregular shape ratio of the glass fiber (B) inside the molded article.

[Table 2]

| | | Example | | | | | | | | Comparative Example | | | | | | | |
|---|---|---|---|---|---|---|---|---|---|---|---|---|---|---|---|---|---|
| | | 1 | 2 | 3 | 4 | 5 | 6 | 7 | 8 | 1 | 2 | 3 | 4 | 5 | 6 | 7 | 8 |
| Thin Wall Flexure | Strength (MPa) | 142 | 147 | 155 | 141 | 145 | 140 | 137 | 140 | 85 | 99 | 114 | 106 | 108 | 115 | 121 | 110 |
| | Elastic Modulus (MPa) | 6200 | 7900 | 8600 | 5900 | 7360 | 7800 | 8100 | 7600 | 4900 | 11200 | 8200 | 7800 | 6500 | 8600 | 7200 | 7800 |
| | Deflection (mm) | 3.8 | 2.9 | 2.7 | 3.6 | 2.9 | 2.7 | 2.7 | 3.1 | 2.9 | 1.7 | 2.1 | 1.9 | 2.6 | 2.2 | 3.4 | 2.2 |
| Reflectance | Initial (450nm) | 91 | 90 | 90 | 91 | 91 | 90 | 90 | 90 | 91 | 85 | 90 | 90 | 92 | 92 | 90 | 88 |
| | After Heating [150°C 336 h] (450nm) | 85 | 85 | 83 | 86 | 84 | 85 | 85 | 85 | 83 | 75 | 84 | 85 | 83 | 83 | 85 | 81 |
| Flowability | 0.5 L/t (Flow Length) | 35 | 33 | 32 | 35 | 39 | 32 | 34 | 34 | 40 | 20 | 36 | 38 | 33 | 29 | 37 | 30 |
| Shrinkage Rate | After Molding - MD | 0.25 | 0.2 | 0.16 | 0.23 | 0.19 | 0.21 | 0.25 | 0.21 | 0.88 | 0.16 | 0.33 | 0.32 | 0.62 | 0.31 | 0.22 | 0.25 |
| | After Molding - TD | 0.59 | 0.55 | 0.52 | 0.47 | 0.39 | 0.56 | 0.58 | 0.55 | 0.95 | 0.68 | 0.68 | 0.69 | 0.81 | 0.72 | 0.56 | 0.57 |
| Glass Fiber After Molding | Minor Axis ($\mu$m) | 6 | 6 | 6 | 7 | 7 | 7 | 6 | 6 | 6 | 6 | 6 | 6 | 9 | 9 | 6 | 6 |
| | Irregular Shape Ratio | 1 | 1 | 1 | 4 | 4 | 4 | 1 | 1 | 1 | 1 | 1 | 1 | 1 | 1 | 1 | 1 |

The polyester resin composition of Comparative Example 1 had too low content of the glass fiber, and thus had low thin wall flexural strength and high shrinkage rate. In addition, the polyester resin composition of Comparative Example 2 had too high content of the glass fiber, and thus had low thin wall flexural strength and low reflectance. Further, it is suggested that the flowability is low, making it difficult to mold the polyester resin composition.

The polyester resin compositions of Comparative Examples 3 and 4 did not contain a modified-ethylene·1-butene copolymer, and thus had low thin wall flexural strength and high shrinkage rate.

In the polyester resin compositions of Comparative Examples 5 and 6, the minor axis of the cross-section of the glass fiber (B3) was 9 $\mu$m, and thus the polyester resin compositions had low thin wall flexural strength and high shrinkage rate. When the minor axis of the glass fiber is large, the contact area with the polyester resin became small, thus weakening the reinforcing effect; but on the other hand, strong orientation is undesirably applied during the injection molding, making the polyester resin composition likely to have a high shrinkage rate.

The polyester resin composition of Comparative Example 7 had too high content of the olefin polymer (D1), and thus had low thin wall flexural strength. Further, the polyester resin composition of Comparative Example 8 contained the olefin polymer (D1) having too large amount of functional group structural units, and thus was likely to suffer coloration caused by denaturation or the like due to heat or light, which resulted in the lowering of reflectance.

In contrast, the polyester resin compositions of Examples 1 to 8 contained a predetermined glass fiber and olefin polymer, and thus had high thin wall flexural strength as well as low shrinkage rate. Moreover, initial reflectance and reflectance after heating were also high. In particular, the polyester resin compositions of Examples 4 to 6 which contained glass fiber (B2) having a higher irregular shape ratio had low shrinkage rate.

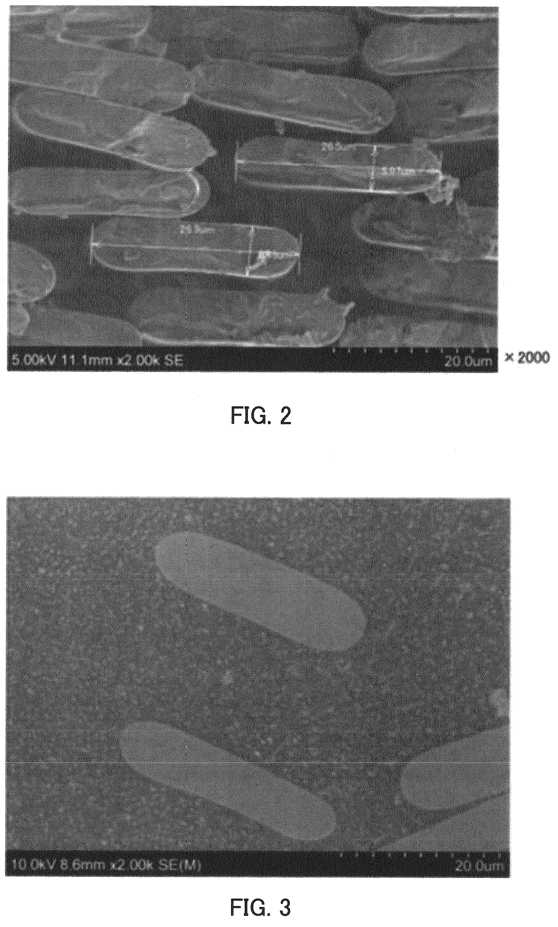

The cross-sectional shape of the glass fibers (B) in the resin composition of Example 5 which is a result of observation under a scanning electron microscope (S-3700N manufactured by Hitachi, Ltd.) is shown in FIG. 2; and the cross-sectional shape of the glass fibers (B) of a molded article (injection-molded product) of this resin composition which is a result of observation under a scanning electron microscope (S-3700N manufactured by Hitachi, Ltd.) is shown in FIG. 3. FIGS. 2 and 3 show that, even after the injection molding, the glass fibers (B) of the injection-molded product maintain the minor axis similar to that of the fiber cross-section before injection molding. Accordingly, it is considered that, in the polyester resin for a reflective material of the present invention, the olefin polymer (D) functions as a cushioning material (protective material) for inhibiting the glass fiber (B) from being broken.

Industrial Applicability

The polyester resin composition for a reflective material of the present invention can be molded into a reflector, and provides a reflector having high strength and low shrinkage rate while having high reflectance.

**Claims**

1. A polyester resin composition for a reflective material, comprising:

    30 to 80% by mass of a polyester resin (A) having a melting point (Tm) or glass transition temperature (Tg) of 250°C or more measured by a differential scanning calorimeter (DSC),
    10 to 35% by mass of a glass fiber (B) having a minor axis of fiber cross-section of 3 to 8 $\mu$m,
    5 to 50% by mass of a white pigment (C), and
    0.3 to 1.5% by mass of an olefin polymer (D) containing 0.2 to 1.8% by mass of a functional group structural unit containing a hetero atom,
    all based on a total of (A), (B), (C) and (D) which is 100% by mass.

2. The polyester resin composition for a reflective material according to claim 1, wherein:

    the polyester resin (A) is a polyester resin (A-1) comprising:

        a dicarboxylic acid component unit (a-1) containing 30 to 100% by mole of a dicarboxylic acid component unit derived from terephthalic acid, and 0 to 70% by mole of an aromatic dicarboxylic acid component unit other than terephthalic acid, and
        a $C_4$-$C_{20}$ alicyclic dialcohol component unit (a-3) and/or aliphatic dialcohol component unit (a-4).

3. The polyester resin composition for a reflective material according to claim 2, wherein the alicyclic dialcohol component unit (a-3) has a cyclohexane skeleton.

4. The polyester resin composition for a reflective material according to claim 1, wherein the ratio between the minor axis and a major axis of the fiber cross-section (irregular shape ratio) of the glass fiber (B) is 3 to 8.

5. The polyester resin composition for a reflective material according to claim 1, wherein the functional group structural unit of the olefin polymer (D) includes a functional group selected from a carboxylic acid, an ester, an ether, an aldehyde and a ketone.

6. The polyester resin composition for a reflective material according to claim 5, wherein the functional group structural unit of the olefin polymer (D) includes a maleic anhydride structural unit.

7. The polyester resin composition for a reflective material according to claim 1, wherein the olefin polymer (D) contains a polyolefin-derived skeleton, and the polyolefin-derived skeleton is a copolymer of ethylene and an olefin having 3 or more carbon atoms.

8. The polyester resin composition for a reflective material according to claim 1, further comprising a phosphorus-containing antioxidant (E).

9. The polyester resin composition for a reflective material according to claim 8, comprising 0 to 10 parts by mass of the phosphorus-containing antioxidant (E) per 100 parts by mass of a total of the polyester resin (A), the glass fiber (B), the white pigment (C) and the olefin polymer (D).

10. A reflector comprising the polyester resin composition for a reflective material according to claim 1.

11. The reflector according to claim 10, which is a reflector for a light-emitting diode element.

COMPLETELY CIRCULAR SHAPE

FIG. 1A

COCOON SHAPE

FIG. 1B

ELLIPTICAL SHAPE

FIG. 1C

FIG. 2

FIG. 3

**INTERNATIONAL SEARCH REPORT**

| International application No. |
|---|
| PCT/JP2014/002455 |

A.   CLASSIFICATION OF SUBJECT MATTER
*C08L67/00*(2006.01)i, *C08K3/00*(2006.01)i, *C08K7/14*(2006.01)i, *H01L33/60*
(2010.01)i

According to International Patent Classification (IPC) or to both national classification and IPC

B.   FIELDS SEARCHED

Minimum documentation searched (classification system followed by classification symbols)
C08L67/00-67/08, C08K3/00-13/08, H01L33/60

Documentation searched other than minimum documentation to the extent that such documents are included in the fields searched
Jitsuyo Shinan Koho          1922-1996   Jitsuyo Shinan Toroku Koho   1996-2014
Kokai Jitsuyo Shinan Koho    1971-2014   Toroku Jitsuyo Shinan Koho   1994-2014

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| X | WO 2013/018360 A1  (Mitsui Chemicals, Inc.), | 1-3,5-11 |
| Y | 07 February 2013 (07.02.2013), | 4 |
| | claims; paragraphs [0023] to [0072], [0087] to | |
| | [0096], [0100] to [0101], [0125] to [0130]; | |
| | examples | |
| | & EP 2740766 A1          & US 2014/167091 A1 | |
| | & JP 2013-32426 A | |
| Y | JP 2013-62491 A  (Dainippon Printing Co., Ltd.), | 4 |
| | 04 April 2013 (04.04.2013), | |
| | claims; paragraph [0073] | |
| | (Family: none) | |

|☒|   Further documents are listed in the continuation of Box C. | ☐   See patent family annex. |
|---|---|---|

| * | Special categories of cited documents: |
|---|---|
| "A" | document defining the general state of the art which is not considered    to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 08 July, 2014 (08.07.14) | 15 July, 2014 (15.07.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
| --- |
| PCT/JP2014/002455 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | JP 2010-270177 A  (Mitsubishi Engineering-Plastics Corp.),<br>02 December 2010 (02.12.2010),<br>claims; paragraphs [0021], [0050] to [0072];<br>examples<br>(Family: none) | 1-11 |
| A | JP 2009-507990 A  (E.I. Du Pont de Nemours & Co.),<br>26 February 2009 (26.02.2009),<br>claims; paragraphs [0009] to [0024]; examples<br>& WO 2007/033129 A2    & US 2007/213458 A1<br>& EP 1925038 A2 | 1-11 |
| A | JP 2009-167318 A  (Toyoda Gosei Co., Ltd.),<br>30 July 2009 (30.07.2009),<br>claims; paragraphs [0010] to [0013]<br>(Family: none) | 4 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009507990 PCT